# EUROPÄISCHE PATENTSCHRIFT

(11) **EP 4 006 568 B1**
(45) Veröffentlichungstag und Bekanntmachung des Hinweises auf die Patenterteilung: **28.01.2026**
(21) Anmeldenummer: 20210670.4
(22) Anmeldetag: 30.11.2020
(51) Int. Cl.: G01R 33/56, G01R 33/565, G01R 33/54

(54) **VERFAHREN ZUM BETRIEB EINER MAGNETRESONANZEINRICHTUNG, MAGNETRESONANZEINRICHTUNG, KORREKTUREINRICHTUNG, COMPUTERPROGRAMM UND ELEKTRONISCH LESBARER DATENTRÄGER**
MAGNETIC RESONANCE DEVICE, METHOD FOR OPERATING A MAGNETIC RESONANCE DEVICE, CORRECTION DEVICE, COMPUTER PROGRAM AND ELECTRONICALLY READABLE DATA CARRIER
PROCÉDÉ DE FONCTIONNEMENT D'UN DISPOSITIF DE RÉSONANCE MAGNÉTIQUE, DISPOSITIF DE RÉSONANCE MAGNÉTIQUE, DISPOSITIF DE CORRECTION, PROGRAMME INFORMATIQUE ET SUPPORT DE DONNÉES LISIBLE DE MANIÈRE ÉLECTRONIQUE

(43) Veröffentlichungstag der Anmeldung: 01.06.2022
(73) Patentinhaber: Siemens Healthineers AG, 91301 Forchheim (DE)
(72) Erfinder: Grodzki, David, 91058 Erlangen (DE); Ritter, Dieter, 90762 Fürth (DE)
(74) Vertreter: Siemens Healthineers Patent Attorneys

(56) Entgegenhaltungen:
- EP-A1- 3 693 751
- US-A1- 2016 169 997
- US-A1- 2016 245 891
- �AVUSOGLU MUSTAFA ET AL: "Correction of parallel transmission using concurrent RF and gradient field monitoring", MAGNETIC RESONANCE MATERIALS IN PHYSICS, BIOLOGY AND MEDICINE, SPRINGER, DE, GB, vol. 30, no. 5, 25 April 2017 (2017-04-25), pages 473 - 488, XP036325393, ISSN: 0968-5243, [retrieved on 20170425], DOI: 10.1007/S10334-017-0620-5

## Beschreibung

Die Erfindung betrifft ein Verfahren zum Betrieb einer Magnetresonanzeinrichtung, die einen ein B0-Feld erzeugenden Hauptmagneten und eine Steuereinrichtung aufweist und zur Aufnahme von Magnetresonanzdaten im Rahmen einer Sequenzpulse umfassenden Magnetresonanzsequenz, wobei die Sequenzpulse wenigstens einen Gradientenpuls und wenigstens einen spektral selektiven Hochfrequenzpuls umfassen, ausgebildet ist, wobei die Steuereinrichtung zur Umsetzung der Sequenzpulse die Sequenzpulse beschreibende Steuerbefehle von einer Sequenzeinheit der Steuereinrichtung an eine Sendeeinrichtung der Magnetresonanzeinrichtung übermittelt. Daneben betrifft die Erfindung eine Magnetresonanzeinrichtung, eine Korrektureinrichtung, ein Computerprogramm und einen elektronisch lesbaren Datenträger.

Die Magnetresonanzbildgebung ist eine etablierte Modalität, insbesondere im Rahmen medizinischer Anwendungen. Magnetresonanzeinrichtungen weisen einen Hauptmagneten auf, der ein Grundmagnetfeld/B0-Feld erzeugt, in dem sich Kernspins eines Patienten, der in eine Patientenaufnahme eingefahren wurde, ausrichten. Mittels Hochfrequenzpulsen bei der Larmor-Frequenz anzuregender Spins in dem B0-Feld, die durch eine Hochfrequenzspulenanordnung ausgesendet werden können, werden die Kernspins in Präzession versetzt, wobei der Zerfall dieser Präzession als Magnetresonanzsignal gemessen werden kann. Eine Ortscodierung wird durch Gradientenpulse erreicht, die beispielsweise durch eine Gradientenspulenanordnung der Magnetresonanzeinrichtung erzeugt werden können. Hierdurch ergeben sich bei Magnetresonanzeinrichtungen so genannte Magnetresonanzsequenzen, die Pulsfolgen von Sequenzpulsen, umfassend Gradientenpulse und Hochfrequenzpulse, umfassen, so dass der Bildgebungsaufgabe entsprechende, messbare Magnetresonanzsignale entstehen. Dabei wird häufig schichtweise gemessen. Die Steuerung bezüglich der Magnetresonanzsequenzen kann beispielsweise durch eine Sequenzeinheit der Magnetresonanzeinrichtung erfolgen, welche entsprechende Steuerbefehle zusammenstellt und diese an eine Sendeeinrichtung übermittelt, an die die Hochfrequenzspulenanordnung und die Gradientenspulenanordnung angeschlossen sein können.

Bei der Magnetresonanzbildgebung spielt die Homogenität des B0-Feldes in vielen Anwendungsbereichen eine wichtige Rolle. Dies gilt insbesondere in der Bildgebung mit Wasserstoffatomen (Protonen), da sich die Larmorfrequenzen von in Fett gebundenen Wasserstoffatomen, die für viele Anwendungen ausgeblendet werden sollen, nur wenig, nämlich um etwa 3,5 ppm, von den Larmor-Frequenzen der in Wasser gebundenen Wasserstoffatome unterscheiden. Beispielsweise dann, wenn durch spektral selektive Hochfrequenzpulse (Anregungspulse) eine Fettsättigung für eine Magnetresonanzmessung erreicht werden soll, können lokale B0-Feldinhomogenitäten bzw. -störungen zu inhomogener oder fehlender Fettsättigung führen oder auch zu dem ungewollten Sättigen von Spins von in Wasser gebundenen Protonen (Wasserstoffatomen). Derartige Artefakte können zu Fehlinterpretationen führen, begründen also wie in anderen Fällen eine schlechte Bildqualität, die insbesondere für die Diagnose ungeeignet sein kann.

Bei Magnetresonanzeinrichtungen existieren verschiedene Gründe für Inhomogenitäten, also Feldabweichungen, insbesondere hinsichtlich des Nennwertes, des B0-Feldes. Beispielsweise können Inhomogenitäten durch die Magnetresonanzeinrichtung selbst oder auch durch den Patienten bzw. dessen Anatomie hervorgerufen werden. Beispielsweise ist es bekannt, dass durch die Anatomie des Patienten im Nacken- oder Fußbereich B0-Feldstörungen bzw. Inhomogenitäten auftreten, die zu so genannten Suszeptibilitätsartefakten führen können. Bei durch die Magnetresonanzeinrichtung bedingten Effekten auf die Homogenität des B0-Feldes kann zwischen statischen Effekten, wie beispielsweise einem inhomogenen B0-Feld durch die Ausführung des Hauptmagneten und/oder nicht ausreichenden Shim, und dynamischen Effekten, wie den Einfluss von Wirbelströmen auf das B0-Feld, unterschieden werden.

Den dynamischen Effekten kommt dabei eine besondere Rolle bei der Bildgebung zu, insbesondere was spektral selektive Hochfrequenzpulse angeht. Insbesondere in außen liegenden Bildbereichen kann der Einfluss von Wirbelströmen beispielsweise ein Problem für die Fettsättigung darstellen. Wirbelströme entstehen insbesondere durch Gradientenpulse, hängen daher vom Gradientenverlauf ab, so dass sie sich im Lauf der Magnetresonanzsequenz, beispielsweise durch unterschiedliche Phasenkodierschritte, verändern.

Im Stand der Technik wurden bereits verschiedene Ansätze vorgeschlagen, um Wirbelströme oder deren Effekte auf die Magnetresonanzbildgebung zu minimieren. Nachdem Wirbelströme auch nach dem Ende von Gradientenpulsen noch für eine gewisse Zeit fortbestehen, wurde vorgeschlagen, Pausen im Messablauf vorzusehen, in denen Wirbelströme abklingen können. Dies geht jedoch nachteilhafterweise auf Kosten der Gesamtaufnahmedauer und gegebenenfalls des Kontrasts.

In einem anderen Ansatz wurde vorgeschlagen, gezielte Gradientenobjekte, beispielsweise zusätzliche Gradientenpulse bzw. überlagerte Gradientenpulse, in den Verlauf der Magnetresonanzsequenz einzufügen, die dem akkumulierten Gradientenmoment auf einer jeweiligen Achse entgegengerichtet sind, um Wirbelströme möglichst weitgehend zu vermeiden oder auszulöschen.

In der nachveröffentlichten deutschen Patentanmeldung DE 10 2020 202 830.3 (internes Aktenzeichen 2020P01375DE) wurde vorgeschlagen, zur Fettsättigung dynamische Hochfrequenzpulse zu verwenden, die die lokalen, zum Zeitpunkt der Fettsättigung vorliegenden B0-Inhomogenitäten ausgleichen, um somit nur auf in Fett gebundene Protonen, konkret deren Spins, sättigend zu wirken. Insbesondere aufgrund längerer Berechnungszeiten wird das dortige Verfahren für die Anwendung bei statischen B0-Inhomogenitäten, mithin statischen Effekten, angewendet, beispielsweise zum Ausgleichen von Suszeptibilitätseffekten im Nackenbereich. Die Korrektur von Artefakten durch dynamische Wirbelstromeffekte, für die das Verfahren grundsätzlich auch geeignet wäre, zeigte sich bislang noch nicht sinnvoll umsetzbar.

Die Druckschrift US 2016/245891 A1 offenbart eine Magnetresonanzeinrichtung mit einer HF-Puls-Wellenform-Erzeugungsschaltung, die Komponenten von Wirbelstrommagnetfeldern und eine Verschiebung der Lamorfrequenz berechnet. Die Druckschrift US 2016/169997 A1 offenbart ein Verfahren zum Betrieb einer Magnetresonanzeinrichtung zur Aufnahme von Bilddaten eines Patienten, wobei ein Justagevorgang zur Anpassung von Betriebsparametern der Magnetresonanzeinrichtung auf den aktuellen Patienten durchgeführt wird.

Der Erfindung liegt daher die Aufgabe zugrunde, eine für dynamische Effekte einsetzbare Möglichkeit zur Reduzierung und/oder Vermeidung von Artefakten, insbesondere durch gradientenausgelöste Wirbelströme, anzugeben.

Diese Aufgabe wird erfindungsgemäß gelöst durch ein Verfahren, eine Magnetresonanzeinrichtung, eine Korrektureinrichtung, ein Computerprogramm und einen elektronisch lesbaren Datenträger gemäß den unabhängigen Patentansprüchen. Vorteilhafte Ausgestaltungen ergeben sich aus den Unteransprüchen.

Ein Verfahren der eingangs genannten Art umfasst erfindungsgemäß folgende Schritte, die in einer zwischen die Sequenzeinheit und die Sendeeinrichtung geschalteten Korrektureinrichtung, durch die Steuerbefehle übertragen werden, ausgeführt werden:
- bei Erhalt eines einen Gradientenpuls betreffenden Steuerbefehls Ermittlung einer die durch den jeweiligen Gradientenpuls verursachten Wirbelströme berücksichtigenden B0-Feldabweichungsinformation, wobei die B0-Feldabweichungsinformation Abweichungen des B0-Feldes von einem Nennwert, auf den bezogen die spektral selektiven Hochfrequenzpulse ermittelt werden, beschreibt, und
- bei Erhalt eines einen spektral selektiven Hochfrequenzpuls beschreibenden Steuerbefehls Überprüfung, ob in einem interessierenden Bereich, der eine als nächste aufzunehmende Schicht ist, ein Schwellwert für erlaubte B0-Feldabweichungen gemäß der B0-Feldabweichungsinformation für den Zeitpunkt der Ausgabe des spektral selektiven Hochfrequenzpulses überschritten wird, wobei bei Überschreitung des Schwellwerts
   ∘ ein die durch die B0-Feldabweichungen gemäß der B0-Feldabweichungsinformation entstehenden Wirkungsabweichungen wenigstens teilweise kompensierender Ersatzpuls für den spektral selektiven Hochfrequenzpuls ermittelt wird und
   ∘ein den Ersatzpuls beschreibender Steuerbefehl statt dem ursprünglichen Steuerbefehl an die Sendeeinrichtung weitergeleitet wird.

Mit anderen Worten wird vorgeschlagen, durch eine Korrektureinrichtung alle Steuerbefehle von der Sequenzeinheit an die Sendeeinrichtung abzufangen, während der Messung vorliegende Wirbelströme und daraus resultierende B0-Feldinhomogenitäten zu ermitteln und dann, wenn die B0-Feldabweichungen zu stark sind, einen spektral selektiven Hochfrequenzpuls durch einen Ersatzpuls auszutauschen. Auf diese Weise können spektral selektive Hochfrequenzpulse, beispielsweise Sättigungspulse, einer beliebigen Magnetresonanzsequenz durch dynamische Ersatzpulse ersetzt werden, sobald insbesondere durch Wirbelströme hervorgerufene B0-Feldinhomogenitäten zum Zeitpunkt der Ausgabe des spektral selektiven Hochfrequenzpulses einen Schwellwert überschreiten, was zu zu starken Wirkungsabweichungen des spektral selektiven Hochfrequenzpulses von der gewünschten Wirkung führen würde. Dabei kann der spektral selektive Hochfrequenzpuls beispielsweise unter Annahme perfekter Homogenität, also dass das B0-Feld überall dem Nennwert entspricht, designt worden sein.

Da diese Maßnahmen durch eine letztlich zur Steuereinrichtung externe, zwischen die Steuereinrichtung und die Sendeeinrichtung geschaltete Korrektureinrichtung, die sozusagen als "black box" wirkt, durchgeführt werden, ist eine besonders einfach umzusetzende Korrektur gegeben, die ohne einen Eingriff in die Magnetresonanzsequenz dynamische Effekte bei B0-Feldinhomogenitäten berücksichtigen kann. Auf diese Weise können Effekte von Wirbelströmen auf die Wirkung von spektral selektiven Hochfrequenzpulsen, insbesondere Sättigungspulsen, verringert bzw. behoben werden, ohne dass dazu die Magnetresonanzsequenz in der Steuereinrichtung angepasst werden müsste. Auf diese Weise kann die Bildqualität der aufgenommenen Magnetresonanzdaten gesteigert werden; zudem ist es auch möglich, Magnetresonanzeinrichtungen mit geringeren Anforderungen an Grenzen für Wirbelströme zu ermöglichen.

Gemäß dem erfindungsgemäßen Verfahren kann ein Benutzer, wie gewohnt, eine Magnetresonanzmessung, die wenigstens eine Magnetresonanzsequenz nutzt, vorbereiten und/oder einstellen und sodann, wie gewohnt, starten. Die von der Sequenzeinheit an die Sendeeinrichtung übermittelten Steuerbefehle werden seitens der Korrektureinrichtung dann analysiert, um, sobald Wirbelströme auslösende Gradientenpulse auftreten, die B0-Feldabweichungsinformationen entsprechend zu aktualisieren bzw. mitzuführen. Hierbei ist es, wie noch genauer dargelegt werden wird, bevorzugt, die Gradientenverläufe der Gradientenpulse auf den physikalischen Achsen auszurollen, wobei dabei für jeden Zeitpunkt die Entwicklung der Wirbelströme mit dem Fachmann grundsätzlich bekannten Methoden berechnet wird. Alternativ oder zusätzlich ist es auch denkbar, Messungen vorzunehmen, beispielsweise mittels in Komponenten der Magnetresonanzeinrichtung integrierten Hall-Sensoren. Die Steuerbefehle werden unverändert an die Sendeeinrichtung der Magnetresonanzeinrichtung weitergeleitet, bis ein einen spektral selektiven Hochfrequenzpuls, der von der Sequenzeinheit an die Sendeeinrichtung gesendet werden soll, beschreibender Steuerbefehl erkannt wird.

Dann wird gemäß der vorliegenden Erfindung untersucht, ob ein Ersatzpuls statt des ursprünglichen spektral selektiven Hochfrequenzpulses verwendet werden soll. In diesem Schritt des Verfahrens werden die B0-Effekte im Bildraum, die wenigstens durch die zum Zeitpunkt des spektral selektiven Hochfrequenzpulses vorliegenden Wirbelströme bestehen, ausgewertet, nachdem sie durch die B0-Feldabweichungsinformationen beschrieben sind. Übersteigt die B0-Feldabweichung in einem interessierenden Bereich, insbesondere also an wenigstens einem Ort von Interesse im Bildraum, einen Schwellwert, soll ein Ersatzpuls ermittelt und verwendet werden. Ist die B0-Feldabweichung, mithin Inhomogenität, jedoch so gering, dass keine oder eine so geringe Frequenzverschiebung gegeben ist, dass die spektrale Bandbreite des ursprünglichen spektral selektiven Hochfrequenzpulses diese noch abdeckt, muss der spektral selektive Hochfrequenzpuls nicht ausgetauscht und der entsprechende Steuerbefehl wird ohne Änderung weitergeleitet und ausgeführt. Ist jedoch eine größere Frequenzverschiebung durch die B0-Feldabweichung gegeben, würde der spektral selektive Hochfrequenzpuls fehlschlagen und es wird ein Ersatzpuls ("dynamischer Puls") verwendet.

Ist der Schwellwert an wenigstens einem Ort von Interesse überschritten, soll mithin ein Austausch erfolgen, wird ein Ersatzpuls ermittelt, der die zum Zeitpunkt der geplanten Ausgabe vorliegenden B0-Feldabweichungen, mithin B0-Feldinhomogenitäten, berücksichtigt. Danach wird der ursprüngliche spektral selektive Hochfrequenzpuls durch den ermittelten Ersatzpuls ersetzt und ein entsprechender Steuerbefehl an die Sendeeinrichtung übermittelt. Fortgefahren wird dann weiterhin mit der Überwachung auf Gradientenpulse beschreibende Steuerbefehle und weitere spektral selektive Hochfrequenzpulse beschreibende Steuerbefehle.

Dabei sei an dieser Stelle angemerkt, dass die Ermittlung der B0-Feldabweichungsinformation, insbesondere auch bei einem Ausrollen des Gradientenpulses, bevorzugt auch für Zeitpunkte nach dem Ende des Gradientenpulses weitergeführt wird, da das Abklingen der Wirbelströme länger andauern kann. Mithin ist insbesondere vorgesehen, dass die Ermittlung der B0-Feldabweichungsinformation bis zu einem Zeitpunkt erfolgt, an dem die durch die Wirbelströme erzeugten B0-Feldabweichungen ein Irrelevanzkriterium erfüllen. Ein solcher Zeitpunkt kann auch beispielsweise durch Berücksichtigung von bei der Inbetriebnahme der Magnetresonanzeinrichtung ermittelten, insbesondere jeweils Kugelfunktionen zugeordneten Zeitkonstanten definiert werden. Solche Zeitkonstanten beschreiben, wie schnell Wirbelströme, die in Komponenten der Magnetresonanzeinrichtung induziert werden, wieder abklingen. Ihre Ermittlung kann beispielsweise durch Testmessungen mit einer Feldkamera beim Anlegen bestimmter Gradientenpulse und dergleichen erfolgen.

In besonders vorteilhafter Ausgestaltung der vorliegenden Erfindung kann vorgesehen sein, dass die B0-Feldabweichungsinformation eine B0-Karte umfasst, die insbesondere auch statische Inhomogenitäten des B0-Feldes beschreibt. Dabei sollen unter statischen Inhomogenitäten des B0-Feldes nicht nur die Eingangs genannten statischen Effekte in der Magnetresonanzeinrichtung selbst verstanden werden, die über die Magnetresonanzmessung mit der wenigstens einen Magnetresonanzsequenz hinweg zumindest im Wesentlichen gleich bleiben, sondern es ist im Rahmen der vorliegenden Erfindung auch denkbar, durch die Anatomie des Patienten entstehende Inhomogenitäten/Feldabweichungen als statisch für die Magnetresonanzmessung zu betrachten, nachdem sich der Patient üblicherweise nach der Positionierung nicht mehr nennenswert bewegt. Beispielsweise ist es im Stand der Technik bekannt, dass vor oder zu Beginn der Messung mit der Magnetresonanzeinrichtung selbst eine B0-Karte aufgenommen wird. Von dieser B0-Karte kann sozusagen als Basis ausgegangen werden, um durch Berücksichtigung der Effekte der jeweiligen Gradientenpulse durch Messung und/oder Ausrollen die B0-Feldabweichungsinformation für letztlich alle relevanten Zeitpunkte innerhalb des gesamten Messvorgangs zu erhalten. Auf diese Weise werden im Übrigen auch statische Inhomogenitäten des B0-Feldes berücksichtigt, wobei sich die B0-Karte und somit die durch die Korrektureinrichtung erreichte Korrektur selbstverständlich zweckmäßig auf nicht anderweitig, beispielsweise durch Shim-Spulen/sonstige Shimeinrichtungen, korrigierte B0-Feldabweichungen bezieht.

Insbesondere bei Verwendung einer B0-Karte, aber auch allgemein, kann also gesagt werden, dass die B0-Feldabweichungsinformation im Sinne einer kontinuierlichen Nachverfolgung aus einer zuvor gültigen, bisherige Gradientenpulse berücksichtigenden B0-Feldabweichungsinformation ermittelt wird. Das bedeutet, die B0-Feldabweichungsinformation wird sozusagen, bevorzugt ausgehend von einer gemessenen B0-Karte, immer mitgeführt, so dass nicht zu jedem Zeitpunkt alle vorausgegangenen Effekte und Einflüsse neu berücksichtigt werden müssen, sondern immer nur die hinzukommenden Effekte, insbesondere Wirbelstromeffekte durch Gradientenpulse, adäquat berücksichtigt werden müssen.

Mit besonderem Vorteil erfolgt anhand der in einem Steuerbefehl, der einen Gradientenpuls beschreibt, enthaltenen Informationen über den Gradientenpuls eine Berechnung der hierdurch entstehenden B0-Feldabweichungen, so dass letztlich der Gradientenpuls in der Korrektureinrichtung ausgerollt wird, um seine Effekte in der B0-Feldabweichungsinformation zu berücksichtigen und überprüfen zu können, ob ein Austausch eines spektral selektiven Hochfrequenzpulses durch einen Ersatzpuls notwendig wird, da die Wirkungsabweichungen von der gewollten Wirkung zu stark wären.

In besonders zweckmäßiger Ausgestaltung ist dabei vorgesehen, dass ein Ausrollen des Gradientenpulses zur Ermittlung der B0-Feldabweichungsinformation unter Verwendung von in einer Kalibrierungsmessung ermittelten, magnetresonanzeinrichtungsspezifischen Wirbelstromamplituden und Zeitkonstanten erfolgt. Das bedeutet, es können grundsätzlich im Stand der Technik bekannte Vorgehensweisen verwendet werden, um die Wirbelstrom-Effekte eines Gradientenpulses auf die B0-Feldhomogenität zu ermitteln. Dabei werden auch die bereits erwähnten, bei der Inbetriebnahme der Magnetresonanzeinrichtung vermessenen Wirbelstrom-Zeitkonstanten wie auch Wirbelstromamplituden genutzt, das bedeutet, Wissen, wie schnell die jeweils erzeugten Wirbelströme in den Komponenten wieder zerfallen und wie stark sie sind. Rein beispielhaft sei hinsichtlich des Standes der Technik hierbei auf DE 197 50 637 B4 verwiesen, wo das durch die Wirbelströme entstehende, durch Phasenbilder bei umgekehrt polarisierten Gradienten vermessene Magnetfeld (Wirbelstromfeld) durch Kugelfunktionen zerlegt wird und auf Basis einer sphärischen harmonischen Zergliederung hieraus Amplituden und Zeitkonstanten abgeleitet werden.

Zusätzlich oder alternativ zu einer Berechnung der B0-Feldabweichungsinformation aus den im Steuerbefehl zur Verfügung stehenden Informationen über den Gradientenpuls ist es auch denkbar, die B0-Feldabweichungsinformation wenigstens teilweise aufgrund einer Messung, insbesondere eines einer Wirbelströme tragenden Komponente der Magnetresonanzeinrichtung zugeordneten Magnetfeldsensors, zu ermitteln. Entsprechende Sensorik wurde im Stand der Technik bereits vorgeschlagen, beispielsweise in Form von in Komponenten integrierten Hall-Sensoren. Werden solche Messungen nicht alternativ zu einer (Voraus-)berechnung verwendet, können sie auch zur Plausibilisierung beispielsweise einer mitgeführten B0-Feldabweichungsinformation, insbesondere einer B0-Karte, vorteilhaft herangezogen werden.

Der interessierende Bereich kann durch das gesamte aufzunehmende Bildgebungsvolumen oder das Blickfeld der Magnetresonanzeinrichtung gebildet sein. Derartige Informationen können grundsätzlich bekannt sein oder aber zumindest bereits aus ersten Steuerbefehlen einer Magnetresonanzsequenz in der Korrektureinrichtung abgeleitet werden. Erfindungsgemäß ist der interessierende Bereich die a1s nächste aufzunehmende Schicht. Sollten derartige Informationen nicht bereits in Steuerbefehlen an die Sendeeinrichtung enthalten sein, sieht eine besonders zweckmäßige Weiterbildung vor, dass der interessierende Bereich aus in Steuerbefehlen enthaltenen Informationen zu wenigstens einem vorangehenden und/oder folgenden Gradientenpuls und/oder Hochfrequenzpuls abgeleitet wird. Sind beispielsweise die für einen Auslesevorgang auszugebenden Gradientenpulse bekannt, kann auch schlussgefolgert werden, welche Schicht angeregt und ausgelesen werden soll. Nachdem vorangehende Gradientenpulse ohnehin bekannt sind und auch entsprechend analysiert werden, sieht eine zweckmäßige Ausgestaltung vor, bekannte Ausgestaltungen, in denen die Steuerbefehle in mehrere Steuerbefehle umfassenden Befehlsblöcken übermittelt werden, auszunutzen. Das bedeutet, es kann vorgesehen sein, dass nicht jeder Steuerbefehl für sich von der Sequenzeinheit an die Sendeeinrichtung übermittelt wird, sondern dies immer blockweise mit mehreren Steuerbefehlen geschieht, so dass neben dem Steuerbefehl für einen spektral selektiven Hochfrequenzpuls zu einem bestimmten Zeitpunkt auch bereits Informationen zu Gradientenpulsen und/oder Hochfrequenzpulsen nach diesem Zeitpunkt vorliegen können, was zur Ermittlung des interessierenden Bereichs als die als nächste aufzunehmende Schicht genutzt werden kann. Mit anderen Worten kann vorgesehen sein, dass der Steuerbefehl, der den spektral selektiven Hochfrequenzpuls beschreibt, in einem mehrere Steuerbefehle umfassenden Befehlsblock übermittelt wird, in dem auch der wenigstens eine Steuerbefehl, der den wenigstens einen auf den spektral selektiven Hochfrequenzpuls folgenden Gradientenpuls und/oder Hochfrequenzpuls beschreibt, enthalten ist.

Ferner ist auch eine Ausgestaltung denkbar, in der nach dem Empfang des Steuerbefehls für den spektral selektiven Hochfrequenzpuls vor der Auswertung und Weiterleitung auf den Empfang eines Steuerbefehls für den wenigstens einen folgenden Gradientenpuls und/oder Hochfrequenzpuls gewartet wird. In dieser Variante wird ausgenutzt, dass es bei spektral selektiven Hochfrequenzpulsen, insbesondere Sättigungspulsen, nicht zwangsläufig auf den exakten Zeitpunkt der Ausgabe ankommt, mithin ein gewisser Puffer existiert, so dass beispielsweise der spektral selektive Hochfrequenzpuls unmittelbar vor einem folgenden Gradientenpuls und/oder Hochfrequenzpuls noch immer ausgegeben werden kann und seine entsprechende Wirkung entfaltet. Auf diese Weise kann mithin unter Ausnutzung von Freiheiten im Zeitablauf ein zusätzlicher Erkenntnisgewinn erreicht werden und insbesondere eine Überprüfung der Überschreitung des Schwellwerts in einem tatsächlich relevanten räumlichen Bereich erfolgen.

Wie bereits erwähnt, ist ein wesentliches Anwendungsgebiet der vorliegenden Erfindung das der Sättigungspulse als spektral selektive Hochfrequenzpulse. Mithin kann vorgesehen sein, dass der spektral selektive Hochfrequenzpuls ein Sättigungspuls für eine bestimmte Spinart ist. Dabei kann es sich insbesondere um einen Fettsättigungspuls handeln, das bedeutet, die Spinart können Spins von in Fett gebundenen Protonen (Wasserstoffatomen) sein. Gerade der Unterschied zwischen den Larmor-Frequenzen von in Wasser gebundenen Protonen und in Fett gebundenen Protonen ist äußerst gering, insbesondere ca. 3,5 ppm, so dass die Wirkung von Fettsättigungspulsen durch Inhomogenitäten des B0-Feldes beeinträchtigt werden kann. Beispielsweise kann ein Sättigungspuls einen bestimmten spektralen Wirkungsverlauf, also ein spektrales Anregungsprofil, aufweisen, welches definiert, auf welche Larmor-Frequenzen der Sättigungspuls wie wirkt. Rutschen nun beispielsweise bei einem Fettsättigungspuls aufgrund von B0-Feldabweichungen Larmor-Frequenzen von in Wasser gebundenen Protonen in den Bereich hoher Wirkung, wird versehentlich Wasser gesättigt, was unerwünscht ist. Anders herum ist es denkbar, dass die Fettsättigung nicht mehr ausreichend ist, da die Larmor-Frequenz der Fettspins durch B0-Feldinhomogenitäten aus dem Bereich hoher Wirkung im Anregungsprofil hinausrutscht. Die vorliegende Erfindung erlaubt es, solche Effekte durch Überprüfung festzustellen und entsprechende Ersatzpulse, die eine demgegenüber verbesserte, insbesondere vollständig die gewünschte, Wirkung entfalten, bereitzustellen.

In konkreter Ausgestaltung der vorliegenden Erfindung kann vorgesehen sein, dass der Schwellwert durch eine maximal zulässige Larmor-Frequenzverschiebung durch die B0-Feldabweichung und/oder anhand des spektralen Wirkungsverlaufs des spektral selektiven Pulses, insbesondere hinsichtlich einer Minimalwirkung und/oder einer Maximalwirkung auf eine bestimmte Spinart, bestimmt wird. Das bedeutet, in den Schwellwert, der insbesondere auch dynamisch abhängig von dem spektral selektiven Hochfrequenzpuls ermittelt werden kann, kann zum einen die letztlich gewünschte spektrale Selektivität eingehen, mithin beispielsweise bei der Wasser-Fett-Trennung der Abstand zwischen den jeweiligen Larmor-Frequenzen, zum anderen aber auch das spektrale Auflösungsvermögen des spektral selektiven Hochfrequenzpulses, mithin dessen spektraler Wirkungsverlauf (spektrales Anregungsprofil). Dabei können beispielsweise zwei Kriterien zur Wahl des Schwellwerts definiert werden und der geringere Wert für den Schwellwert kann herangezogen werden. So wird der Schwellwert ideal auf die Bildgebungsaufgabe, insbesondere die gewünschte spektrale Wirkung des spektral selektiven Hochfrequenzpulses, angepasst, um konkret für den spektral selektiven Hochfrequenzpuls zu ermitteln, ob ein Problem hinsichtlich seiner Wirkung durch die B0-Feldabweichung gegeben ist.

Bezüglich des Ersatzpulses ist es zweckmäßig, diesen möglichst schnell, insbesondere in Echtzeit, bereitstellen zu können, um einen schnellen und reibungslosen Austausch des ursprünglichen Steuerbefehls, der den spektral selektiven Hochfrequenzpuls betrifft, durch einen den Ersatzpuls betreffenden Steuerbefehl umsetzen zu können. Nachdem explizite Berechnungen, beispielsweise im Rahmen des Optimierungsverfahrens, wie es in der nachveröffentlichten, eingangs genannten DE 10 2020 202 830.3 beschrieben wurde, längere Zeit in Anspruch nehmen können, wird es im Rahmen der vorliegenden Erfindung bevorzugt, dass zur Ermittlung des Ersatzpulses in Abhängigkeit von der B0-Feldabweichungsinformation, insbesondere in dem interessierenden Bereich, ein Ermittlungsalgorithmus der künstlichen Intelligenz, insbesondere umfassend ein neuronales Netzwerk, und/oder eine Datenbank verwendet wird. Insbesondere können in einer derartigen Datenbank Ersatzpulse zugeordnet zu Referenz-B0-Feldabweichungsinformationen gespeichert sein, wobei der Ersatzpuls, dessen Referenz-B0-Feldabweichungsinformation am bestem mit der aktuellen B0-Feldabweichungsinformation, insbesondere für den interessierenden Bereich, zum Zeitpunkt der Ausgabe des spektral selektiven Hochfrequenzpulses übereinstimmt, ausgewählt wird. Einträge für Ersatzpulse in der Datenbank können beispielsweise durch Simulation und/oder Berechnung, insbesondere die Verwendung eines Optimierungsverfahrens für typische Referenz-B0-Feldabweichungsinformationen, ermittelt sein. Denkbar ist es jedoch auch, Messungen durchzuführen. Dies gilt analog für Trainingsdaten zum Trainieren des Ermittlungsalgorithmus der künstlichen Intelligenz, die ebenso beispielsweise anhand des in der nachveröffentlichten, bereits zitierten DE 10 2020 202 830.3 genannten Optimierungsverfahrens und/oder im Rahmen von Simulationen ermittelt werden können. Der Ermittlungsalgorithmus der künstlichen Intelligenz kann ein neurales Netz, insbesondere ein Convolutional Neural Network (CNN) umfassen. Als Eingangsdaten kann er beispielsweise die B0-Feldabweichungsinformation zum Zeitpunkt der Ausgabe des spektral selektiven Hochfrequenzpulses oder eine Abstraktion, beispielsweise durch Downsampling, der B0-Feldabweichungsinformation nutzen. Der Vorteil eines Ermittlungsalgorithmus der künstlichen Intelligenz ist insbesondere, dass auf diese Weise deutlich schneller als mit herkömmlichen Optimierungsverfahren der Ersatzpuls ermittelt werden kann.

Im Allgemeinen bildet ein Algorithmus der künstlichen Intelligenz, der auch als trainierte Funktion bezeichnet werden kann, kognitive Funktionen ab, die Menschen mit dem Geist anderer Menschen assoziieren. Durch Trainieren mittels Trainingsdaten (Maschinenlernen) ist die trainierte Funktion fähig, sich an neue Umstände anzupassen und Muster zu erkennen und zu extrapolieren.

Allgemein gesagt können Parameter einer trainierten Funktion durch Training angepasst werden. Beispielsweise können überwachtes Lernen, halbüberwachtes Lernen, nichtüberwachtes Lernen, Reinforcement Learning und/oder aktives Lernen verwendet werden. Auch sogenanntes "Representation Learning" (auch als "Feature Learning" bekannt) kann eingesetzt werden. Die Parameter einer trainierten Funktion können durch iterative Adaption angepasst werden.

Insbesondere kann eine trainierte Funktion ein neuronales Netz, eine Support Vector Machine, einen Entscheidungsbaum und/oder ein Bayesisches Netzwerk umfassen und/oder die trainierte Funktion kann auf k-means Clustering, Q-Lernen, genetischen Algorithmen und/oder Zuordnungsregeln basieren. Ein neuronales Netz kann insbesondere ein tiefes neuronales Netz, ein Convolutional Neural Network (CNN) oder ein tiefes Convolutional Neural Network sein. Darüber hinaus kann ein neuronales Netz ein Adversarial Network, ein tiefes Adversarial Network und/oder ein Generative Adversarial Network (GAN) sein.

Die hier beschriebene zwischengeschaltete Korrekturlösung kann auch mit weiteren, zwischen die Sequenzeinheit und die Sendeeinrichtung geschalteten Korrekturlösungen kombiniert werden. Diese können beispielsweise eine Glättung von Gradientenpulsen und dergleichen betreffen. Sollten weitere Korrekturmaßnahmen, die ebenso in der Korrektureinrichtung realisiert werden können, die Gradientenpulse betreffen, ist es allerdings zweckmäßig, diese dem potentiellen Austausch von spektral selektiven Anregungspulsen vorzuschalten, da dieser ja auf der konkreten, dann auch umzusetzenden Form der Gradientenpulse basieren wird. Mit anderen Worten ist es denkbar, dass die Korrektureinrichtung eine erste Korrektureinheit zur Ermittlung und Auswertung der B0-Feldabweichungsinformation aufweist, der eine zweite Korrektureinheit vorgeschaltet ist, die der Anpassung von Gradientenpulsen für eine schnellere Messung und/oder Lärmvermeidung dient, wobei bei einer Nutzung des Gradientenpulses zur Ermittlung der B0-Feldabweichungsinformation der angepasste Gradientenpuls verwendet wird. Eine entsprechende zweite Korrektureinheit und deren Funktion sind beispielsweise in DE 10 2013 202 559 B3 beschrieben, in welcher es um eine Optimierung einer MR-Pulssequenz durch automatisches Optimieren von Gradientenpulsen in veränderbaren Intervallen geht.

Neben dem Verfahren betrifft die Erfindung auch eine Magnetresonanzeinrichtung, die einen ein B0-Feld erzeugenden Hauptmagneten und eine Steuereinrichtung aufweist und zur Aufnahme von Magnetresonanzdaten im Rahmen einer Sequenzpulse umfassenden Magnetresonanzsequenz mit wenigstens einem Gradientenpuls und wenigstens einem spektral selektiven Hochfrequenzpuls ausgebildet ist, wobei die Steuereinrichtung zur Umsetzung der Sequenzpulse die Sequenzpulse beschreibende Steuerbefehle von einer Sequenzeinheit der Steuereinrichtung an eine Sendeeinrichtung der Magnetresonanzeinrichtung übermittelt, wobei die Magnetresonanzeinrichtung sich dadurch auszeichnet, dass zwischen die Sequenzeinheit und die Sendeeinrichtung eine Korrektureinrichtung geschaltet ist, die zur Durchführung des erfindungsgemäßen Verfahrens ausgebildet ist. Sämtliche Ausführungen bezüglich des erfindungsgemäßen Verfahrens lassen sich analog auf die erfindungsgemäße Magnetresonanzeinrichtung übertragen, so dass mit dieser die bereits genannten Vorteile erhalten werden können.

Eine erfindungsgemäße Korrektureinrichtung für eine erfindungsgemäße Magnetresonanzeinrichtung ist zum Zwischenschaltung zwischen die Sequenzeinheit und die Sendeeinrichtung und zur Durchführung des erfindungsgemäßen Verfahrens ausgebildet. Auch für die erfindungsgemäße Korrektureinrichtung, die beispielsweise zum Nachrüsten einer Magnetresonanzeinrichtung eingesetzt werden kann, gelten die Ausführungen zum erfindungsgemäßen Verfahren und auch zur Magnetresonanzeinrichtung entsprechend fort.

Sowohl für die Magnetresonanzeinrichtung wie auch für die Korrektureinrichtung gilt, dass die Korrektureinrichtung wenigstens einen Prozessor und wenigstens ein Speichermittel aufweisen kann. Insbesondere kann die Korrektureinrichtung eine Ermittlungseinheit zur Ermittlung der B0-Feldabweichungsinformation, eine Überprüfungseinheit zur Überprüfung, ob eine hinreichende Wirkung eines spektral selektiven Hochfrequenzpulses gegeben ist, und eine Austauscheinheit zur Ermittlung eines Ersatzpulses und zum Weiterleiten eines entsprechend ausgetauschten Steuerbefehls aufweisen.

Ein erfindungsgemäßes Computerprogramm ist in ein Speichermittel einer Korrektureinrichtung ladbar, die zwischen eine Steuereinrichtung und eine Sendeeinrichtung einer Magnetresonanzeinrichtung schaltbar ist. Wird das Computerprogramm in der Korrektureinrichtung ausgeführt, werden die Schritte eines erfindungsgemäßen Verfahrens durchgeführt. Das Computerprogramm kann auf einem elektronisch lesbaren Datenträger gemäß der Erfindung gespeichert sein, welcher mithin Steuerinformationen umfasst, die bei Verwendung des Datenträgers in einer erfindungsgemäßen Korrektureinrichtung bzw. einer Korrektureinrichtung einer erfindungsgemäßen Magnetresonanzeinrichtung die Korrektureinrichtung dazu veranlassen, die Schritte eines erfindungsgemäßen Verfahrens durchzuführen. Bei dem Datenträger kann es sich um einen nichttransienten Datenträger, insbesondere eine CD-ROM, handeln.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: einen Ablaufplan eines Ausführungsbeispiels des erfindungsgemäßen Verfahrens,
- Fig. 2: eine erfindungsgemäße Magnetresonanzeinrichtung und
- Fig. 3: den funktionalen Aufbau einer Korrektureinrichtung.

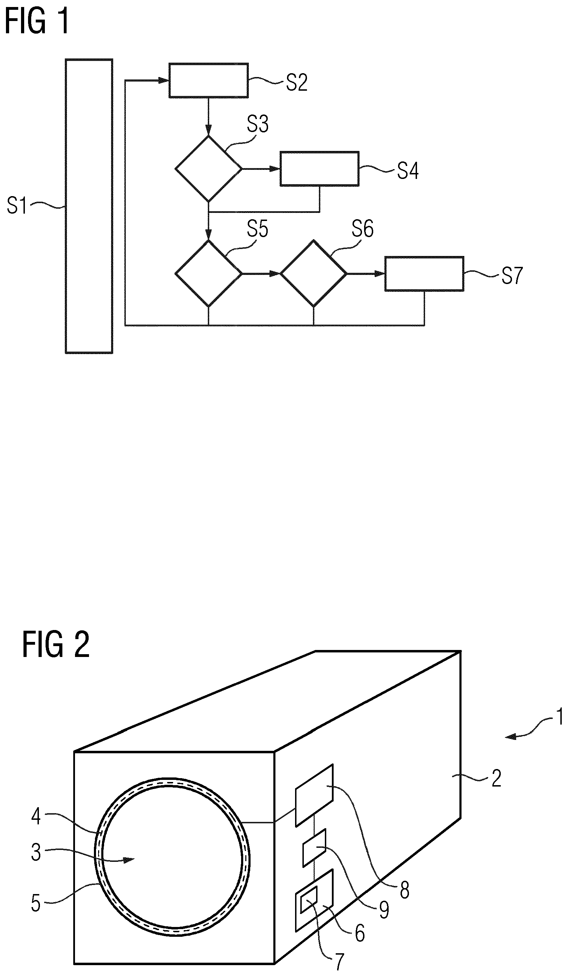

Fig. 1 zeigt einen Ablaufplan eines Ausführungsbeispiels des erfindungsgemäßen Verfahrens. Dieses findet im Rahmen eines Magnetresonanzdatenaufnahmevorgangs, angedeutet durch den Schritt S1, statt, wobei zur Aufnahme der Magnetresonanzdaten wenigstens eine Magnetresonanzsequenz verwendet wird. Die Magnetresonanzsequenz umfasst, wie grundsätzlich bekannt, Sequenzpulse, wobei die Sequenzpulse insbesondere Gradientenpulse und Hochfrequenzpulse (Anregungspulse) umfassen können. Insbesondere wird in wenigstens einer der wenigstens einen Magnetresonanzsequenz auch wenigstens ein spektral selektiver Hochfrequenzpuls genutzt, vorliegend ein Fettsättigungspuls, mit dem eine Sättigung der Magnetisierung von in Fett gebundenen Protonen erreicht werden soll.

Die hierbei verwendete Magnetresonanzeinrichtung weist, wie bekannt, eine Gradientenspulenanordnung und eine Hochfrequenzspulenanordnung auf, wobei letztere auch Lokalspulen umfassen kann. Bevorzugt weist die Gradientenspulenanordnung Gradientenspulen für die X-Achse, die Y-Achse und die Z-Achse auf, während die Hochfrequenzspulenanordnung mehrkanalig ansteuerbar ist. Über eine Sendeeinrichtung werden mittels der Hochfrequenzspulenanordnung und der Gradientenspulenanordnung die Sequenzpulse, insbesondere also die Gradientenpulse und die Hochfrequenzpulse, erzeugt. Die Magnetresonanzeinrichtung weist auch eine Steuereinrichtung auf, in welcher die wenigstens eine Magnetresonanzsequenz in einer Sequenzeinheit umgesetzt wird. Die Sequenzeinheit der Steuereinrichtung überträgt Steuerbefehle zur Umsetzung der entsprechenden einzelnen Sequenzpulse an die Sendeeinrichtung. Dies geschieht im vorliegenden Beispiel jeweils als ein Befehlsblock, der mehrere Steuerbefehle enthält, in einem Schritt S2.

Zwischen die Sequenzeinheit und die Sendeeinrichtung ist nun eine Korrektureinrichtung geschaltet, die eine erste und optional eine zweite Korrektureinheit aufweist. Die optionale zweite Korrektureinheit ist der ersten Korrektureinheit vorgeschaltet und vorliegend der Einfachheit halber nicht durch einen Schritt repräsentiert. In der zweiten Korrektureinheit können, falls vorgesehen, Gradientenpulse optimiert werden, indem die entsprechenden Steuerbefehle, die Gradientenpulse beschreiben, abgefangen werden und entsprechend angepasst bzw. ersetzt werden, um optimierte Gradientenpulse wiederzugeben, wie dies beispielsweise in DE 10 2013 202 559 B3 beschrieben ist.

Auch in der ersten Korrektureinheit der Korrektureinrichtung werden die Steuerbefehle analysiert. In einem Schritt S3 wird überprüft, ob der Steuerbefehl einen Gradientenpuls beschreibt. Ist dies der Fall, wird mit einem Schritt S4 fortgefahren. Im Schritt S4 wird der durch den Steuerbefehl beschriebene Gradientenpuls ausgerollt, beispielsweise unter Verwendung von bei Inbetriebnahme der Magnetresonanzeinrichtung und/oder periodisch in einer Kalibrierungsmessung vermessenen, magneteinrichtungsspezifischen Wirbelstromamplituden und Zeitkonstanten, um, insbesondere ausgehend von einer statische Effekte abbildenden, zu Beginn des Aufnahmevorgangs ermittelten B0-Karte, eine B0-Feldabweichungsinformation zu ermitteln. Die B0-Feldabweichungsinformation beschreibt wenigstens die durch aufgrund des Gradientenpulses entstehende Wirbelströme auftretende B0-Feldabweichungen, also Inhomogenitäten des B0-Feldes, für jeden relevanten Zeitpunkt des Aufnahmevorgangs, wobei beispielsweise abhängig vom konkreten Gradientenpuls und den Zeitkonstanten ein Vorausberechnungszeitraum definiert werden kann, für den das Ausrollen und die Berechnung von B0-Feldabweichungsinformationen, insbesondere in Form von B0-Karten, erfolgt, wobei mit jedem neuen Gradientenpuls eine entsprechende Aktualisierung erfolgt, in dem die entsprechenden Wirbelstrom-Effekte hinzugefügt werden. Wie bereits erwähnt, wird dabei bevorzugt auch eine Beschreibung statischer Effekte geliefert.

Mit anderen Worten kann gesagt werden, dass die dynamischen Effekte auf das B0-Feld, mithin durch aufgrund von durch Gradientenpulse entstehenden Wirbelströmen auftretende B0-Feldabweichungen, ständig mitgeführt werden und aktuell in der Korrektureinrichtung vorliegen.

In einem Schritt S5 wird überprüft, ob ein Steuerbefehl vorliegt, der die Ausgabe eines spektral selektiven Hochfrequenzpulses, hier wie beschrieben eines Fettsättigungspulses, betrifft. Trifft dies zu, findet in einem Schritt S6 eine Überprüfung statt, ob relevante, die Wirkung des spektral selektiven Hochfrequenzpulses zu stark beeinflussende B0-Feldabweichungen aufgrund der B0-Feldabweichungsinformation vorliegen. Dabei wird konkret überprüft, ob die B0-Feldabweichung innerhalb eines interessierenden Bereichs im Bildraum wenigstens teilweise einen Schwellwert überschreitet. Dazu ist zunächst der interessierende Bereich festzulegen, zum anderen aber auch der Schwellwert.

Zum Festlegen des interessierenden Bereichs kann vorgesehen sein, dass dieser als das Blickfeld der Magnetresonanzeinrichtung oder das gesamte aufzunehmende Bildgebungsvolumen, aus dem Magnetresonanzdaten gemessen werden sollen, festgelegt ist. Bevorzugt ist es im Schritt S6 jedoch, die zuletzt vor dem spektral selektiven Hochfrequenzpuls ausgegebenen und, aufgrund der Übermittlung in Befehlsblöcken, auf den spektral selektiven Hochfrequenzpuls folgenden Gradienten und/oder Hochfrequenzpulse auszuwerten, um zu ermitteln, welche Schicht bzw. Schichten als nächstes aufgenommen werden und von den durch den Gradientenpuls induzierten Wirbelstrom-Effekten beeinflusst werden könnten, so dass letztlich die Überprüfung im Schritt S6 auf einen relevanten Bereich, auf den der spektral selektive Hochfrequenzpuls wirken soll, beschränkt werden kann.

Auch bezüglich des Schwellwerts kann eine Festlegung getroffen werden, insbesondere eine generelle Festlegung oder eine Festlegung für verschiedene Klassen von spektral selektiven Hochfrequenzpulsen. Bevorzugt wird jedoch auch hier eine dynamische Ermittlung anhand von zwei Kriterien vorgenommen. So kann zum einen eine absolute Beschränkung festgelegt werden, die sich an der gewünschten Wirkung des spektral selektiven Hochfrequenzpulses orientiert. Im hier diskutierten Beispiel des Fettsättigungspulses ist beispielsweise bekannt, dass die Larmor-Frequenzen von den in Fett gebundenen Protonen und in Wasser gebundenen Protonen als unterschiedliche Spinarten derart auseinander liegen, dass für die Fettspins eine um - 3,5 ppm niedrigere Resonanzfrequenz gegeben ist als für die Wasserspins. Hier kann beispielsweise eine Grenze bei -2,5 oder -3,0 ppm festgelegt sein. Besonders bevorzugt zusätzlich, oder auch alternativ, wird jedoch der spektrale Wirkungsverlauf, also das spektrale Anregungsprofil, des spektral selektiven Hochfrequenzpulses, der durch den aktuell betrachteten Steuerbefehl beschrieben wird, berücksichtigt, um dynamisch einen Schwellwert zu bestimmen. Dabei ist zu beachten, dass dieser spektrale Wirkungsverlauf üblicherweise keine "Sprungfunktion" darstellt, sondern im Übergangsbereich zwischen den unterschiedlichen Spinarten, auf die er wirken soll, einen kontinuierlichen, sich über einen Frequenzbereich erstreckenden Verlauf annimmt, insbesondere von der maximalen Wirkung für die Spinart, auf die der spektral selektive Hochfrequenzpuls ausgerichtet ist, hin zu der minimalen Wirkung auf die Spinart, die er nicht betreffen soll. Bezüglich dieses Wirkungsverlaufs kann beispielsweise festgelegt werden, dass auch bei B0-Feldabweichungen wenigstens noch 80 % der Wirkung auf die angezielte Spinart vorliegen sollen und/oder höchstens 20 % der Wirkung auf die nicht angezielte Spinart vorliegen soll. Auch hieraus ergeben sich mithin Schwellwerte, wobei bei Betrachtung beider Kriterien der jeweils niedrigste Wert herangezogen werden kann. Mit anderen Worten kann der Schwellwert durch eine maximale Frequenzverschiebung durch die B0-Feldabweichung gegeben sein und vom spektralen Wirkungsverlauf des ursprünglich in der Magnetresonanzsequenz zu verwendenden spektral selektiven Hochfrequenzpulses abhängen.

Auf diese Weise kann also unterschieden werden zwischen durch B0-Feldabweichungen auftretenden Frequenzverschiebungen, die innerhalb der spektralen Bandbreite des ursprünglichen spektral selektiven Hochfrequenzpulses liegen, und solchen, die größer als der Schwellwert sind. Ist die Frequenzverschiebung der Larmor-Frequenzen so gering, dass die Magnetisierung von Spins von in Fett gebundenen Protonen trotz der Verschiebung bei einem Sättigungspuls weiterhin gesättigt wird und keine unabsichtliche Sättigung der Magnetisierung von Spins von in Wasser gebundenen Protonen stattfindet, muss der spektral selektive Hochfrequenzpuls nicht verändert werden, so dass der entsprechende Steuerbefehl ohne Änderung weitergeleitet und ausgeführt werden kann. Ist jedoch die Frequenzverschiebung größer, würde die Fettsättigung fehlschlagen bzw. sogar eine ungewollte Wassersättigung eintreten, ist also der Schwellwert an wenigstens einer Stelle innerhalb des interessierenden Bereichs überschritten, soll gemäß des Verfahrens der ursprüngliche spektral selektive Hochfrequenzpuls durch einen Ersatzpuls ersetzt werden und es wird in einem Schritt S7 fortgefahren.

Im Schritt S7 wird ein solcher Ersatzpuls in Abhängigkeit von der B0-Feldabweichungsinformation für den interessierenden Bereich ermittelt. Mit anderen Worten erfolgt die Ermittlung derart, dass die zum Zeitpunkt der Ausgabe des Ersatzpulses vorliegenden B0-Inhomogenitäten im interessierenden Bereich berücksichtigt werden, wie dies beispielsweise in der bereits genannten, nachveröffentlichten DE 10 2020 202 830.3 beschrieben ist. Allerdings ist die dort vorgeschlagene explizite Ermittlung mittels eines Optimierungsverfahrens weniger bevorzugt, da eine besonders schnelle Ermittlung des Ersatzpulses, insbesondere in Echtzeit, zweckmäßig ist. Um eine derartige, schnelle Ermittlung des Ersatzpulses zu begünstigen, sind im Rahmen des Schrittes S7 zwei Möglichkeiten denkbar.

Zum einen kann vorgesehen sein, dass ein Ermittlungsalgorithmus der künstlichen Intelligenz für den Ersatzpuls verwendet wird. In der anderen Variante kann eine Datenbank vorliegen, in der Ersatzpulse bestimmten Referenz-B0-Feldabweichungsinformationen zugeordnet sind. In beiden Fällen werden die auf den Zeitpunkt der Ausgabe des Ersatzpulses bezogenen B0-Feldabweichungsinformationen als Eingangsdaten verwendet, wobei im Fall der Datenbank die ähnlichste Referenz-B0-Feldabweichungsinformation aufgefunden und der entsprechend zugeordnete Ersatzpuls verwendet wird. Sowohl Einträge in der Datenbank als auch Trainingsdaten für den Ermittlungsalgorithmus der künstlichen Intelligenz können durch Simulation und/oder Berechnung ermittelt werden, da zu diesem Zeitpunkt hinreichende Zeit vorliegt, um beispielsweise das in DE 10 2020 202 830.3 beschriebene Optimierungsverfahren einzusetzen, insbesondere beispielsweise mittels Bloch-Gleichungen die Spin-Anregung in Abhängigkeit von der B0-Feldabweichungsinformation, insbesondere einer B0-Feldkarte der B0-Feldabweichungsinformation, und dem potentiellen Ersatzpuls zu ermitteln und Abweichungen von der gewollten spektral selektiven Wirkung zu minimieren, bis diese unter einer vorbestimmten Abweichung liegen. Ebenso im Schritt S7 wird dann der Steuerbefehl für den ursprünglichen, spektral selektiven Hochfrequenzpuls durch einen Steuerbefehl für den Ersatzpuls ersetzt und entsprechend an die Sendeeinrichtung weitergeleitet.

Auf diese Weise, insbesondere also im Durchlauf der Schritte S3 bis S7, wird fortgefahren, bis der Aufnahmevorgang beendet ist.

Es sei an dieser Stelle angemerkt, dass insbesondere für Ausführungsbeispiele, in denen keine Befehlsblöcke, sondern einzelne Steuerbefehle übersendet werden, jedoch auch dann, wenn der Befehlsblock wenige Informationen für nach dem spektral selektiven Hochfrequenzpuls erfolgende Sequenzpulse enthält, auch eine Variante denkbar ist, in der nach Empfang eines einen spektral selektiven Hochfrequenzpuls beschreibenden Steuerbefehls gewartet wird, bis ein Steuerbefehl für einen nachfolgenden Gradientenpuls und/oder Hochfrequenzpuls erhalten wird, so dass dann beispielsweise die Information nachfolgender Steuerbefehle zur Ermittlung des interessierenden Bereichs noch herangezogen werden können und der spektral selektive Hochfrequenzpuls bzw. Ersatzpuls beispielsweise unmittelbar vor dem Beginn eines nachfolgenden Gradientenpulses und/oder Hochfrequenzpulses noch ausgegeben werden kann.

Fig. 2 zeigt eine Prinzipskizze einer erfindungsgemäßen Magnetresonanzeinrichtung 1. Diese weist, wie grundsätzlich bekannt, eine Hauptmagneteinheit 2 auf, in der der insbesondere supraleitend ausgeführte Hauptmagnet zur Erzeugung des B0-Feldes (Hauptmagnetfeldes) mit einem bestimmten Nennwert im Homogenitätsvolumen/Blickfeld der Magnetresonanzeinrichtung 1 angeordnet ist. Die Hauptmagneteinheit 2 weist eine Patientenaufnahme 3, in die beispielsweise mittels einer nicht näher gezeigten Patientenliege ein Patient eingefahren werden kann, auf. Die Patientenaufnahme 3 umgebend sind vorliegend eine Hochfrequenzspulenanordnung 4 und eine Gradientenspulenanordnung 5 angeordnet, wobei insbesondere hinsichtlich der Hochfrequenzspulenanordnung 4 diese auch als Lokalspulenanordnung ausgeführt sein kann und/oder Lokalspulen umfassen kann, die beispielsweise auf und/oder in der Patientenliege und/oder dem Patienten angeordnet werden können. Die Gradientenspulenanordnung 5 umfasst Gradientenspulen für jede der drei kartesischen Hauptachsen, insbesondere also für die X-Richtung, die Y-Richtung und die Z-Richtung. Die Hochfrequenzspulenanordnung 4 weist mehrere unabhängig ansteuerbare Hochfrequenzspulen auf, so dass insbesondere durch unabhängige Ansteuerung der so entstehenden Hochfrequenzkanäle räumlich unterschiedliche Anregungsmuster entstehen können.

Der Betrieb der Magnetresonanzeinrichtung 1 wird durch eine Steuereinrichtung 6 gesteuert, die eine Sequenzeinheit 7 aufweist, in der zur Durchführung eines Aufnahmevorgangs mit wenigstens einer Magnetresonanzsequenz Steuerbefehle für die Sequenzpulse erzeugt werden und an eine der Hochfrequenzspulenanordnung 4 und der Gradientenspulenanordnung 5 zugeordnete Sendeeinrichtung 8 übermittelt werden. Zwischen die Steuereinrichtung 6 und die Sendeeinrichtung 8 ist eine Korrektureinrichtung 9 geschaltet, die zur Durchführung des erfindungsgemäßen Verfahrens ausgebildet ist, insbesondere also Steuerbefehle mitlesen/abfangen kann, um die B0-Feldabweichungsinformation bezüglich der Gradientenpulse mitzuführen und bei auf spektral selektive Hochfrequenzpulse bezogenen Steuerbefehlen zu überprüfen, ob deren Wirkung in gewünschtem Maße gegeben ist, wobei bei einem Fehlschlag dieser Überprüfung ein Ersatzpuls ermittelt werden kann und der Steuerbefehl für den ursprünglich geplanten spektral selektiven Hochfrequenzpuls durch einen Steuerbefehl für den Ersatzpuls ersetzt werden kann.

Sowohl die Steuereinrichtung 6 als auch die Korrektureinrichtung 9 sind in Fig. 2 schematisch an der Hauptmagneteinheit 2 gezeigt, können jedoch selbstverständlich auch wenigstens teilweise außerhalb einer entsprechenden Baueinheit bzw. außerhalb einer Schirmkabine, in der die Hauptmagneteinheit 2 angeordnet ist, vorgesehen sein.

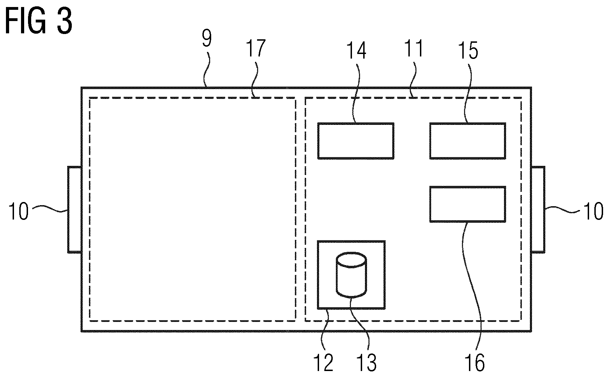

Fig. 3 zeigt den funktionalen Aufbau der Korrektureinrichtung 9. Diese weist zunächst Schnittstellen 10 für die Entgegennahme von Steuerbefehlen der Sequenzeinheit 7 und deren Weiterleitung/Ausgabe auf. Vorliegend umfasst die Korrektureinrichtung 9, realisiert durch wenigstens einen Prozessor, eine erste Korrektureinheit 11 mit verschiedenen Funktionseinheiten auf, um die Schritte des erfindungsgemäßen Verfahrens ausführen zu können. Zudem ist auch ein Speichermittel 12 vorgesehen, in dem verschiedene Informationen kurzzeitig oder längerfristig gespeichert werden können, insbesondere auch die erwähnte Datenbank 13.

Die erste Korrektureinheit 11 weist eine Ermittlungseinheit 14 zur Ermittlung der B0-Feldabweichungsinformation gemäß den Schritten S3 und S4 auf. Zudem ist eine Überprüfungseinheit 15 vorgesehen, in der die Schritte S5 und S6 durchgeführt werden können. Ergibt die Überprüfung, dass ein Austausch des spektral selektiven Hochfrequenzpulses notwendig ist, kann der entsprechende Ersatzpuls in einer Austauscheinheit 16 gemäß dem Schritt 7, beispielsweise unter Nutzung der Datenbank 13, ermittelt werden und der entsprechende Steuerbefehl erzeugt werden, um dann über die ausgangsseitige Schnittstelle 10 ausgegeben zu werden und den ursprünglichen Steuerbefehl für den spektral selektiven Hochfrequenzpuls zu ersetzen, wie bezüglich Schritt S7 beschrieben.

Der ersten Korrektureinheit 11 kann optional eine zweite Korrektureinheit 17 vorgeschaltet sein, die der Optimierung der Gradientenpulse dienen kann, wie dies beispielsweise ausführlich in DE 10 2013 202 559 B3 beschrieben ist. Auf diese Weise können die Vorteile einer Gradientenoptimierung und einer Mitführung von B0-Inhomogenitäten anhand der B0-Feldinformation sowie eines gegebenenfalls notwendigen korrigierenden Austauschs eines spektral selektiven Hochfrequenzpulses kombiniert werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu ver1assen, welcher durch die Ansprüche definiert ist.

## Patentansprüche

1. Verfahren zum Betrieb einer Magnetresonanzeinrichtung (1), die einen ein B0-Feld erzeugenden Hauptmagneten und eine Steuereinrichtung (6) aufweist und zur Aufnahme von Magnetresonanzdaten im Rahmen einer Sequenzpulse umfassenden Magnetresonanzsequenz ausgebildet ist,
wobei die Sequenzpulse wenigstens einen Gradientenpuls und wenigstens einen spektral selektiven Hochfrequenzpuls umfassen,
wobei die Steuereinrichtung (6) zur Umsetzung der Sequenzpulse die Sequenzpulse beschreibende Steuerbefehle von einer Sequenzeinheit (7) der Steuereinrichtung (6) an eine Sendeeinrichtung (8) der Magnetresonanzeinrichtung (1) übermittelt, wobei in einer Korrektureinrichtung (9), die zwischen die Sequenzeinheit (7) und die Sendeeinrichtung (8) geschaltet ist und durch die die Steuerbefehle übertragen werden,
- bei Erhalt eines Steuerbefehls, der einen Gradientenpuls betrifft, eine B0-Feldabweichungsinformation ermittelt wird, die die durch den jeweiligen Gradientenpuls verursachten Wirbelströme berücksichtigt,
wobei die B0-Feldabweichungsinformation Abweichungen des B0-Feldes von einem Nennwert, auf den bezogen die spektral selektiven Hochfrequenzpulse ermittelt werden, beschreibt,
**dadurch gekennzeichnet, dass**
- bei Erhalt eines Steuerbefehls, der einen spektral selektiven Hochfrequenzpuls beschreibt, überprüft wird, ob in einem interessierenden Bereich, der eine als nächste aufzunehmende Schicht ist, ein Schwellwert für erlaubte B0-Feldabweichungen gemäß der B0-Feldabweichungsinformation für den Zeitpunkt der Ausgabe des spektral selektiven Hochfrequenzpulses überschritten wird,
wobei bei Überschreitung des Schwellwerts ein Ersatzpuls, der die durch die B0-Feldabweichungen gemäß der B0-Feldabweichungsinformation entstehenden Wirkungsabweichungen wenigstens teilweise kompensiert, für den spektral selektiven Hochfrequenzpuls ermittelt wird und ein den Ersatzpuls beschreibender Steuerbefehl statt dem ursprünglichen Steuerbefehl an die Sendeeinrichtung (8) weitergeleitet wird.

2. Verfahren nach Anspruch 1, **dadurch gekennzeichnet, dass** die B0-Feldabweichungsinformation eine B0-Karte umfasst, die insbesondere auch statische Inhomogenitäten des B0-Feldes beschreibt.

3. Verfahren nach Anspruch 1 oder 2, **dadurch gekennzeichnet,**
**dass** die B0-Feldabweichungsinformation im Sinne einer kontinuierlichen Nachverfolgung aus einer zuvor gültigen, bisherige Gradientenpulse berücksichtigenden B0-Feldabweichungsinformation ermittelt wird und/oder
**dass** ein Ausrollen des Gradientenpulses zur Ermittlung der B0-Feldabweichungsinformation unter Verwendung von in einer Kalibrierungsmessung ermittelten, magnetresonanzeinrichtungsspezifischen Wirbelstromamplituden und Zeitkonstanten erfolgt und/oder
**dass** die B0-Feldabweichungsinformation wenigstens teilweise aufgrund einer Messung, insbesondere eines Magnetfeldsensors, dem eine Wirbelströme tragenden Komponente der Magnetresonanzeinrichtung (1) zugeordnet ist, ermittelt wird.

4. Verfahren nach einem der vorangehenden Ansprüche,
**dadurch gekennzeichnet,**
**dass** der spektral selektive Hochfrequenzpuls ein Sättigungspuls für eine bestimmte Spinart, insbesondere Spins von in Fett gebundenen Protonen, ist.

5. Verfahren nach einem der vorangehenden Ansprüche,
**dadurch gekennzeichnet,**
**dass** der Schwellwert durch eine maximal zulässige Larmorfrequenzverschiebung durch die B0-Feldabweichung und/oder anhand des spektralen Wirkungsverlaufs des spektral selektiven Pulses, insbesondere hinsichtlich einer Minimalwirkung und/oder einer Maximalwirkung auf eine bestimmte Spinart, bestimmt wird.

6. Verfahren nach einem der vorangehenden Ansprüche,
**dadurch gekennzeichnet,**
**dass** zur Ermittlung des Ersatzpulses in Abhängigkeit von der B0-Feldabweichungsinformation, insbesondere in dem interessierenden Bereich, ein Ermittlungsalgorithmus der künstlichen Intelligenz, insbesondere umfassend ein neuronales Netzwerk, und/oder eine Datenbank (13) verwendet wird.

7. Verfahren nach Anspruch 6, **dadurch gekennzeichnet,**
**dass** in der Datenbank (13) Ersatzpulse zugeordnet zu Referenz-B0-Feldabweichungsinformationen gespeichert sind,
wobei der Ersatzpuls, dessen Referenz-B0-Feldabweichungsinformation am besten mit der aktuellen B0-Feldabweichungsinformation, insbesondere für den interessierenden Bereich, zum Zeitpunkt der Ausgabe des spektral selektiven Hochfrequenzpulses übereinstimmt, ausgewählt wird.

8. Verfahren nach einem der vorangehenden Ansprüche,
**dadurch gekennzeichnet,**
**dass** die Korrektureinrichtung (9) eine erste Korrektureinheit (11) zur Ermittlung und Auswertung der B0-Feldabweichungsinformation aufweist, der eine zweite Korrektureinheit (17) vorgeschaltet ist, die der Anpassung von Gradientenpulsen für eine schnellere Messung und/oder Lärmvermeidung dient,
wobei bei einer Nutzung des Gradientenpulses zur Ermittlung der B0-Feldabweichungsinformation der angepasste Gradientenpuls verwendet wird.

9. Korrektureinrichtung (9) für eine Magnetresonanzeinrichtung (1) gemäß dem Oberbegriff von Anspruch 10, welche zum Zwischenschalten zwischen der Sequenzeinheit (7) und der Sendeeinrichtung (8) der Magnetresonanzvorrichtung (1) und zur Durchführung eines Verfahrens nach einem der Ansprüche 1 bis 8 ausgebildet ist.

10. Magnetresonanzeinrichtung (1), die einen ein B0-Feld erzeugenden Hauptmagneten und eine Steuereinrichtung (6) aufweist und zur Aufnahme von Magnetresonanzdaten im Rahmen einer Sequenzpulse umfassenden Magnetresonanzsequenz mit wenigstens einem Gradientenpuls und wenigstens einem spektral selektiven Hochfrequenzpuls ausgebildet ist, wobei die Steuereinrichtung (6) zur Umsetzung der Sequenzpulse die Sequenzpulse beschreibende Steuerbefehle von einer Sequenzeinheit (7) der Steuereinrichtung (6) an eine Sendeeinrichtung (8) der Magnetresonanzeinrichtung (1) übermittelt, **dadurch gekennzeichnet, dass** zwischen die Sequenzeinheit (7) und die Sendeeinrichtung (8) eine Korrektureinrichtung (9) nach Anspruch 9 geschaltet ist.

11. Computerprogramm, welches die Schritte eines Verfahrens nach einem der Ansprüche 1 bis 8 durchführt, wenn es in einer Korrektureinrichtung (9) nach Anspruch 9 einer Magnetresonanzeinrichtung (1) nach Anspruch 10 ausgeführt wird.

12. Elektronisch lesbarer Datenträger, auf dem ein Computerprogramm nach Anspruch 11 gespeichert ist.

## Claims

1. Method for operating a magnetic resonance facility (1), which has a main magnet that generates a B0 field and a control facility (6) and is designed to record magnetic resonance data in the context of a magnetic resonance sequence comprising sequence pulses,
wherein the sequence pulses comprise at least one gradient pulse and at least one spectrally selective radio frequency pulse,
wherein the control facility (6) transmits control commands describing the sequence pulses for implementing the sequence pulses from a sequence unit (7) of the control facility (6) to a transmission facility (8) of the magnetic resonance facility (1),
wherein in a correction facility (9) which is connected between the sequence unit (7) and the transmission facility (8) and by way of which the control commands are transmitted,
- on receipt of a control command relating to a gradient pulse, an item of B0 field deviation information is ascertained, which takes into account the eddy currents caused by the respective gradient pulse,
wherein the B0 field deviation information describes deviations of the B0 field from a nominal value, relating to which the spectrally selective radio frequency pulses are ascertained,
**characterised in that**
- on receipt of a control command which describes a spectrally selective radio frequency pulse, it is checked whether, in a region of interest, which is a slice to be recorded next, a threshold value for permitted B0 field deviations according to the B0 field deviation information for the time instant of the output of the spectrally selective radio frequency pulse is exceeded, wherein when the threshold value is exceeded, a substitute pulse which at least partially compensates for effective deviations resulting from the B0 field deviations according to the B0 field deviation information, for which spectrally selective radio frequency pulse is ascertained and a control command describing the substitute pulse is forwarded to the transmission facility (8) instead of the original control command.

2. Method according to claim 1, **characterised in that** the B0 field deviation information comprises a B0 map which also describes in particular static inhomogenities of the B0 field.

3. Method according to claim 1 or 2, **characterised in that**, in the context of continuous tracking, the B0 field deviation information is ascertained from a previously valid item of B0 field deviation information which takes into account previous gradient pulses and/or
extending the gradient pulse to ascertain the B0 field deviation information is effected using magnetic resonance facility-specific eddy current amplitudes and time constants ascertained in a calibration measurement
and/or
the B0 field deviation information is at least partially ascertained on the basis of a measurement, in particular of a magnetic field sensor, to which a component of the magnetic resonance facility (1) which carries eddy currents is assigned.

4. Method according to one of the preceding claims,
**characterised in that**
the spectrally selective radio frequency pulse is a saturation pulse for a particular type of spin, in particular spins of protons bound in fat.

5. Method according to one of the preceding claims,
**characterised in that**
the threshold value is determined by a maximum permissible Larmor frequency shift by the B0 field deviation and/or on the basis of the spectral response curve of the spectrally selective pulse, in particular regarding a minimum effect and/or a maximum effect on a particular type of spin.

6. Method according to one of the preceding claims,
**characterised in that**,
as a function of the B0 field deviation information, in particular in the region of interest, an artificial intelligence ascertainment algorithm is used, in particular comprising a neural network and/or a database (13), for ascertaining the substitute pulse.

7. Method according to claim 6, **characterised in that** substitute pulses assigned to reference B0 field deviation information are stored in the database (13), wherein the substitute pulse is selected, the reference B0 field deviation information of which corresponds the most with the current B0 field deviation information, in particular for the region of interest, at the time instant of the output of the spectrally selective radio frequency pulse.

8. Method according to one of the preceding claims,
**characterised in that**
the correction facility (9) has a first correction unit (11) for ascertaining and evaluating the B0 field information,
which has a second correction unit (17) connected upstream,
which serves for adjusting gradient pulses for a faster measurement and/or to avoid noise,
wherein the adjusted gradient pulse is used during application of the gradient pulse for ascertaining the B0 field deviation information.

9. Correction facility (9) for a magnetic resonance facility (1) according to the precharacterising clause of claim 10, which is designed for interposing between the sequence unit (7) and the transmission facility (8) of the magnetic resonance apparatus (1) and for carrying out a method according to one of claims 1 to 8.

10. Magnetic resonance facility, which has a main magnet that generates a B0 field and a control facility (6), and which is designed to record magnetic resonance data in the context of a magnetic resonance sequence comprising sequence pulses with at least one gradient pulse and at least one spectrally selective radio frequency pulse, wherein the control facility (6) transmits control commands describing the sequence pulses for implementing the sequence pulses from a sequence unit (7) of the control facility (6) to a transmission facility (8) of the magnetic resonance facility (1), **characterised in that** a correction facility (9) according to claim 9 is connected between the sequence unit (7) and the transmission facility (8).

11. Computer program, which performs the steps of a method according to one of claims 1 to 8 when it is executed in a correction facility (9) according to claim 9 of a magnetic resonance facility (1) according to claim 10.

12. Electronically readable data carrier on which a computer program according to claim 11 is stored.

## Revendications

1. Procédé pour faire fonctionner un dispositif (1) de résonnance magnétique, qui a un aimant principal produisant un champ B0 et un dispositif (6) de commande et qui est constitué pour l'enregistrement de données de résonnance magnétique, dans le cadre d'une séquence de résonnance magnétique comprenant des impulsions de séquence,
dans lequel les impulsions de séquence comprennent au moins une impulsion de gradient et au moins une impulsion de haute fréquence à sélection de spectre,
dans lequel le dispositif (6) de commande transmet, pour la conversion des impulsions de séquence, des instructions de commande, décrivant les impulsions de séquence d'une unité (7) de séquence du dispositif (6) de commande, à un dispositif (8) d'émission du dispositif (1) de résonnance magnétique, dans lequel,
dans un dispositif (9) de correction, qui est monté entre l'unité (7) de séquence et le dispositif (8) d'émission et par lequel les instructions de commande sont transmises,
- à la réception d'une instruction de commande, qui concerne une impulsion de gradient, est déterminée une information d'écarts de champ B0, qui prend en compte les courants de Foucault provoqués par l'impulsion de gradient respective,
dans lequel l'information d'écarts de champ B0 décrit des écarts du champ B0 à une valeur nominale, rapportée à laquelle les impulsions de haute fréquence à sélection de spectre sont déterminées,
**caractérisé en ce que**
- à la réception d'une instruction de commande, qui décrit une impulsion de haute fréquence à sélection de spectre, on contrôle si, dans une région à laquelle on s'intéresse, qui est une coupe à enregistrer la plus proche, une valeur de seuil, pour des écarts de champs B0 autorisés suivant l'information d'écarts de champ B0, est dépassée à l'instant de l'émission de l'impulsion de haute fréquence à sélection de spectre,
dans lequel, au dépassement de la valeur de seuil, on détermine, pour l'impulsion à haute fréquence à sélection de spectre, une impulsion de remplacement, qui compense au moins en partie les écarts d'effet créés par les écarts de champ B0 suivant l'information d'écarts de champ B0, et on achemine, au dispositif (8) d'émission, une instruction de commande décrivant l'impulsion de remplacement au lieu de l'impulsion de commande d'origine.

2. Procédé suivant la revendication 1, **caractérisé en ce que** l'information d'écarts du champ B0 comprend une carte B0, qui décrit en particulier également des défauts d'homogénéité statiques du champ B0.

3. Procédé suivant la revendication 1 ou 2, **caractérisé en ce que**
l'on détermine l'information d'écarts de champ B0, au sens d'un suivi continu à partir d'une information d'écarts de champ B0 prenant en compte des impulsions de gradient jusqu'ici valables auparavant et/ou
a lieu un déroulement de l'impulsion de gradient, pour la détermination de l'information d'écarts de champ B0 en utilisant des amplitudes de courant de Foucault, déterminées dans une mesure d'étalonnage et spécifiques à un dispositif de résonnance magnétique, et des constantes de temps et/ou
**en ce que** l'on détermine l'information d'écarts de champ B0 au moins en partie sur la base de la mesure, en particulier d'un capteur de champ magnétique, qui est affecté à un composant portant des courants de Foucault du dispositif (1) de résonnance magnétique.

4. Procédé suivant l'une des revendications précédentes, **caractérisé**
**en ce que** l'impulsion de haute fréquence à sélection de spectre est une impulsion de saturation d'un type de spin déterminé, en particulier de spins de protons associés à de la graisse.

5. Procédé suivant l'une des revendications précédentes, **caractérisé**
**en ce que** l'on détermine la valeur de seuil par un décalage de fréquence de Larmor admissible au maximum par l'écart de champ B0 et/ou à l'aide de la courbe d'effet spectrale de l'impulsion à sélection de spectre, en particulier en ce qui concerne un effet minimum et/ou un effet maximum sur un type de spin déterminé.

6. Procédé suivant l'une des revendications précédentes, **caractérisé**
**en ce que**, pour la détermination de l'impulsion de remplacement en fonction de l'information d'écarts de champ B0, en particulier dans la partie intéressante, on utilise un algorithme de détermination de l'intelligence artificielle comprenant, en particulier, un réseau neuronal et/ou une base (13) de données.

7. Procédé suivant la revendication 6, **caractérisé en ce que**, sont mises en mémoire dans la base (13) de données, des impulsions de remplacement associées à des informations d'écarts de champ B0 de référence, dans lequel on sélectionne l'impulsion de remplacement, dont l'information d'écarts de champ B0 de référence coïncide au mieux avec l'information d'écarts de champ B0 en cours, en particulier pour la partie à laquelle l'on s'intéresse, à l'instant de l'émission de l'impulsion de haute fréquence à sélection de spectre.

8. Procédé suivant l'une des revendications précédentes, **caractérisé**
**en ce que** le dispositif (9) de correction a une première unité (11) de correction pour la détermination et l'évaluation de l'information d'écarts de champ B0, qui est montée en amont d'une deuxième unité (17) de correction, qui sert à l'adaptation de d'impulsion de gradient pour une mesure rapide et/ou à empêcher du bruit,
dans lequel, lors de l'utilisation de l'impulsion de gradient pour la détermination de l'information d'écarts de champ B0, on utilise l'impulsion de gradient adaptée.

9. Dispositif (9) de correction pour un dispositif (1) de résonnance magnétique suivant le préambule de la revendication 10, qui est constitué pour l'interposition entre l'unité (7) de séquençage et le dispositif (8) d'émission du dispositif (1) et pour effectuer un procédé suivant l'une des revendications 1 à 8.

10. Dispositif (1) de résonnance magnétique, qui a un aimant principal produisant un champ B0 et un dispositif (6) de commande et, pour l'enregistrement de données de résonnance magnétique dans le cadre d'une séquence de résonnance magnétique comprenant des impulsions de séquence ayant au moins une impulsion de gradient et au moins une impulsion de haute fréquence à sélection de spectre, dans lequel le dispositif (6) de commande transmet, pour la conversion des impulsions de séquence, des instructions de commande décrivant les impulsions de séquence d'une unité (7) de séquence du dispositif (6) de commande à un dispositif (8) d'émission du dispositif (1) de résonnance magnétique, **caractérisé en ce qu'**un dispositif (9) de correction, suivant la revendication 9, est monté entre l'unité (7) de séquençage et le dispositif (8) d'émission.

11. Programme d'ordinateur, qui effectue les stades d'un procédé suivant l'une des revendications 1 à 8, lorsqu'il est exécuté dans un dispositif (9) de correction suivant la revendication 9 d'un dispositif (1) de résonnance magnétique suivant la revendication 10.

12. Support de données déchiffrable électroniquement, sur lequel est mis en mémoire un programme d'ordinateur suivant la revendication 11.
